# EUROPEAN PATENT APPLICATION

(11) **EP 4 579 259 A1**
(43) Date of publication of application: **02.07.2025**
(21) Application number: 22959154.0
(22) Date of filing: 22.09.2022
(51) Int. Cl.: G01R 31/392

(54) **SOH TESTING METHOD AND APPARATUS AND ENERGY STORAGE SYSTEM**

(71) Applicant: CONTEMPORARY AMPEREX TECHNOLOGY (HONG KONG) LIMITED, Central (HK)
(72) Inventor: LIN, Longzhen, Ningde, Fujian 352100 (CN); LIU, Diping, Ningde, Fujian 352100 (CN); CHEN, Shaoyan, Ningde, Fujian 352100 (CN)
(74) Representative: Ziebig Hengelhaupt Intellectual Property Attorneys Patentanwaltskanzlei PartGmbB
(86) International application number: PCT/CN2022/120613
(87) International publication number: WO 2024/060146

(57) **Abstract**

This application discloses an SOH detection method and apparatus, and an energy storage system. A main controller in the method can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

## Description

### TECHNICAL FIELD

This application relates to the field of batteries, and in particular, to an SOH detection method and apparatus, and an energy storage system.

### BACKGROUND

In an energy storage system, a battery pack is typically required to store excess power. However, the battery pack will age after long-term use. The available capacity of the aged battery pack is decreased, thereby deteriorating the state of health (SOH) of the battery pack. To ensure safe and stable operation of the energy storage system, the SOH value of the battery pack needs to be detected.

However, the SOH detection scheme in the related art is prone to a problem of detection errors and a low detection precision.

### SUMMARY

In view of the problems above, this application provides an SOH detection method and apparatus and an energy storage system to solve the problem of a low precision of SOH detection in the related art.

According to a first aspect, this application provides an SOH detection method. The method is applied to a main controller of an energy storage system, and the method includes:
sending an SOH detection instruction to a battery manager of a battery pack in the energy storage system, where the SOH detection instruction is used for instructing the battery manager to determine an allowable charge or discharge power of the battery pack;
receiving the allowable charge or discharge power sent by the battery manager, and adjusting an output power of a power generation module in the energy storage system based on the allowable charge or discharge power, so as to cause the output power of the power generation module to charge or discharge the battery pack while satisfying a required system power; and
receiving the SOH value of the battery pack sent by the battery manager, where the SOH value of the battery pack is determined after completion of charging or discharging the battery pack.

This embodiment of this application provides an SOH detection method. In this method, the main controller can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

In some embodiments, the adjusting an output power of a power generation module in the energy storage system based on the allowable charge or discharge power includes:
sending a first charge power of the battery pack determined based on the allowable charge or discharge power to the battery manager, so as to instruct the battery manager to control, based on the first charge power, the battery pack to undergo charging, where the first charge power is equal to a difference between the output power of the power generation module and the required system power;
controlling, upon receiving a first charge stop request sent by the battery manager, the power generation module to stop charging the battery pack;
sending a first discharge power of the battery pack determined based on the allowable charge or discharge power to the battery manager, so as to instruct the battery manager to control, based on the first discharge power, the battery pack to undergo discharging, where the first discharge power is equal to a difference between the required system power and the output power of the power generation module; and
controlling, upon receiving a first discharge stop request sent by the battery manager, the battery pack to stop discharging.

The output power of the power generation module in the energy storage system is adjusted based on the allowable charge or discharge power. This causes the output power of the power generation module to charge and then discharge the battery pack for one cycle while satisfying the required system power.

In some embodiments, the adjusting an output power of a power generation module in the energy storage system based on the allowable charge or discharge power further includes:
controlling, after controlling the power generation module to stop charging the battery pack, the output power of the power generation module to be equal to the required system power so as to leave the battery pack to stand statically. This eliminates the polarization phenomenon caused by the charging of the battery pack, thereby obtaining the currently available capacity of the battery pack accurately.

In some embodiments, the adjusting an output power of a power generation module in the energy storage system based on the allowable charge or discharge power further includes:
controlling, after controlling the battery pack to stop discharging, the output power of the power generation module to be equal to the required system power so as to leave the battery pack to stand statically. This eliminates the polarization phenomenon caused by the discharging of the battery pack, thereby obtaining the currently available capacity of the battery pack accurately.

In some embodiments, the adjusting an output power of a power generation module in the energy storage system based on the allowable charge or discharge power includes:
sending a second discharge power of the battery pack determined based on the allowable charge or discharge power to the battery manager, so as to instruct the battery manager to control, based on the second discharge power, the battery pack to undergo discharging, where the second discharge power is equal to a difference between the required system power and the output power of the power generation module;
controlling, upon receiving a second discharge stop request sent by the battery manager, the battery pack to stop discharging;
sending a second charge power of the battery pack determined based on the allowable charge or discharge power to the battery manager, so as to instruct the battery manager to control, based on the second charge power, the battery pack to undergo charging, where the second charge power is equal to a difference between the output power of the power generation module and the required system power; and
controlling, upon receiving a second charge stop request sent by the battery manager, the power generation module to stop charging the battery pack.

The output power of the power generation module in the energy storage system is adjusted based on the allowable charge or discharge power. This causes the output power of the power generation module to discharge and then charge the battery pack for one cycle while satisfying the required system power.

In some embodiments, the adjusting an output power of a power generation module in the energy storage system based on the allowable charge or discharge power further includes:
controlling, after controlling the battery pack to stop discharging, the output power of the power generation module to be equal to the required system power so as to leave the battery pack to stand statically. This eliminates the polarization phenomenon caused by the discharging of the battery pack, thereby obtaining the currently available capacity of the battery pack accurately.

In some embodiments, the adjusting an output power of a power generation module in the energy storage system based on the allowable charge or discharge power further includes:
controlling, after controlling the power generation module to stop charging the battery pack, the output power of the power generation module to be equal to the required system power so as to leave the battery pack to stand statically. This eliminates the polarization phenomenon caused by the charging of the battery pack, thereby obtaining the currently available capacity of the battery pack accurately.

In some embodiments, the sending an SOH detection instruction to a battery manager of a battery pack in the energy storage system includes:
sending the SOH detection instruction to the battery manager of the battery pack in the energy storage system when it is determined that the output power of the power generation module is greater than the required system power for a duration greater than or equal to a preset SOH detection duration. In this way, the SOH detection is implemented automatically.

According to a second aspect, an SOH detection method is provided. The method is applied to a battery manager of a battery pack in an energy storage system, and the method includes:
determining an allowable charge or discharge power of the battery pack in response to an SOH detection instruction sent by a main controller of the energy storage system;
sending the allowable charge or discharge power to the main controller, so that the main controller adjusts an output power of a power generation module in the energy storage system based on the allowable charge or discharge power, so as to cause the output power of the power generation module to charge or discharge the battery pack while satisfying a required system power; and
determining an available capacity of the battery pack upon completion of charging or discharging the battery pack, and calculating an SOH value of the battery pack based on the available capacity.

This embodiment of this application provides an SOH detection method. In this method, the battery manager sends the allowable charge or discharge power to the main controller, thereby instructing the main controller to adjust the output power of the power generation module based on the allowable charge or discharge power. In this way, the output power of the power generation module charges or discharges the battery pack while satisfying the required system power, thereby enabling the battery pack to complete a full charging or discharging process. In this way, the battery manager can obtain the currently available capacity of the battery pack accurately and implement precise calculation of the SOH value.

In some embodiments, the charging or discharging the battery pack include:
controlling, based on a first charge power sent by the main controller, the battery pack to undergo charging, where the first charge power is equal to a difference between the output power of the power generation module and the required system power;
sending, upon determining that the battery pack is fully charged, a first charge stop request to the main controller, so as to instruct the main controller to control the power generation module to stop charging the battery pack;
controlling, based on a first discharge power sent by the main controller, the battery pack to undergo discharging, where the first discharge power is equal to a difference between the required system power and the output power of the power generation module; and
sending a first discharge stop request to the main controller upon determining that the battery pack is fully discharged, so as to instruct the main controller to control the battery pack to stop discharging.

In some embodiments, the first charge stop request is further used for instructing the main controller to control, after controlling the power generation module to stop charging the battery pack, the output power of the power generation module to be equal to the required system power so as to leave the battery pack to stand statically.

In some embodiments, the first discharge stop request is further used for instructing the main controller to control, after controlling the battery pack to stop discharging, the output power of the power generation module to be equal to the required system power so as to leave the battery pack to stand statically.

In some embodiments, the charging or discharging the battery pack include:
controlling, based on a second discharge power sent by the main controller, the battery pack to undergo discharging;
sending a second discharge stop request to the main controller upon determining that the battery pack is fully discharged, so as to instruct the main controller to control the battery pack to stop discharging;
controlling, based on a second charge power sent by the main controller, the battery pack to undergo charging; and
sending, upon determining that the battery pack is fully charged, a second charge stop request to the main controller, so as to instruct the main controller to control the power generation module to stop charging the battery pack.

In some embodiments, the second charge stop request is further used for instructing the main controller to control, after controlling the power generation module to stop charging the battery pack, the output power of the power generation module to be equal to the required system power so as to leave the battery pack to stand statically.

In some embodiments, the second discharge stop request is further used for instructing the main controller to control, after controlling the battery pack to stop discharging, the output power of the power generation module to be equal to the required system power so as to leave the battery pack to stand statically.

In some embodiments, the SOH detection instruction is sent by the main controller when determining that the output power of the power generation module is greater than the required system power for a duration greater than or equal to a preset SOH detection duration.

According to a third aspect, a computer-readable storage medium is provided. The computer-readable storage medium stores a computer program. When executed by a computer device, the computer program causes the computer device to implement the SOH detection method disclosed in the above aspect.

According to a fourth aspect, a main controller of an energy storage system is provided. The main controller includes a memory and a processor. The memory stores a computer program. When executed by the processor, the computer program causes the main controller to implement the SOH detection method disclosed in the above aspect.

According to a fifth aspect, a battery manager of a battery pack in an energy storage system is provided. The battery manager includes a memory and a processor. The memory stores a computer program. When executed by the processor, the computer program causes the battery manager to implement the SOH detection method disclosed in the above aspect.

According to a sixth aspect, an energy storage system is provided. The energy storage system includes a power generation module, an energy conversion module, a battery pack, and a main controller. The energy conversion module is configured to convert electrical energy generated by the power generation module, so as to charge the battery pack and/or supply power to an external device, or is configured to convert electrical energy provided by the battery pack, so as to supply power to an external device.

The main controller is configured to send an SOH detection instruction to a battery manager in the battery pack.

The battery manager is configured to determine an allowable charge or discharge power of the battery pack upon receiving the SOH detection instruction, and send the allowable charge or discharge power to the main controller.

The main controller is further configured to adjust an output power of the power generation module based on the allowable charge or discharge power, so that when converted by the energy conversion module, the output power of the power generation module satisfies a required system power for supplying power to an external device and a charge or discharge power for charging or discharging the battery pack.

The battery manager is further configured to determine an available capacity of the battery pack upon completion of charging or discharging the battery pack, calculate an SOH value of the battery pack based on the available capacity, and send the SOH value of the battery pack to the main controller.

Additional aspects and advantages of this application will be partly given in the following description, and a part thereof will become evident in the following description or will be learned in the practice of this application.

### BRIEF DESCRIPTION OF DRAWINGS

FIG. 1 is a schematic structural diagram of an energy storage system according to an embodiment of this application;
FIG. 2 is a flowchart of an SOH detection method according to an embodiment of this application;
FIG. 3 is a flowchart of another SOH detection method according to an embodiment of this application;
FIG. 4 is a flowchart of still another SOH detection method according to an embodiment of this application;
FIG. 5 is a flowchart of yet another SOH detection method according to an embodiment of this application;
FIG. 6 is a schematic structural diagram of a main controller according to an embodiment of this application;
FIG. 7 is a schematic structural diagram of a battery manager according to an embodiment of this application;
FIG. 8 is a block diagram of an SOH detection apparatus according to an embodiment of this application;
FIG. 9 is a block diagram of another SOH detection apparatus according to an embodiment of this application; and
FIG. 10 is a block diagram of still another SOH detection apparatus according to an embodiment of this application.

### DETAILED DESCRIPTION OF EMBODIMENTS

The following describes some embodiments of this application in detail. Examples of the embodiments are shown in the drawings, throughout which the same or similar reference numerals represent the same or similar components or the components of the same or similar functions. The embodiments described below with reference to the drawings are exemplary, and are intended to construe this application but not to limit this application.

Currently, a battery pack usually needs to be mounted in an energy storage system to store excess electricity. The battery pack may be a lithium battery. The lifespan of the battery pack is generally required to be 20 to 25 years. However, the battery pack will age after long-term use. The available capacity of the aged battery pack is decreased, thereby deteriorating the state of health (SOH) of the battery pack. To ensure safe and stable operation of the energy storage system, the SOH value of the battery pack needs to be detected.

In the related art, the SOH detection is usually performed during the use of the battery pack. Specifically, when the battery pack is in a low-current state or a statically standing state, an open-circuit voltage (open circuit voltage, OCV) of a battery cell in the battery pack is obtained by looking up a table, and a SOC value corresponding to the open-circuit voltage of the battery cell is obtained based on a pre-plotted OCV-state of charge (state of charge, SOC) value relation curve. Subsequently, a charge capacity or discharge capacity accumulated during this period is calculated based on the obtained SOC value, and an actual available capacity of the battery pack is estimated based on the charge capacity or discharge capacity. Finally, the SOH value is determined based on the actual available capacity.

However, after long-term use of the battery pack, the OCV-SOC relation curve changes with the aging of the battery pack. Therefore, the SOC value determined based on the relation curve is different from the actual SOC value, thereby resulting in a low accuracy of the determined SOC value, and in turn, leading to a low accuracy of the determined SOH value. In addition, charging or discharging the battery pack at the same charge or discharge current poses an overcurrent risk. Moreover, the SOH detection requires the battery pack to be in a low-current state or a statically standing state, and the charge or discharge current of the battery pack is controlled based on the operating conditions of the battery pack, thereby being unable to fully satisfy the SOH detection.

An embodiment of this application provides an SOH detection method. A main controller in the method can allocate energy based on an output power of a power generation module, an allowable charge or discharge power of a battery pack, and a required system power, so as to cause the output power of the power generation module to charge or discharge the battery pack while satisfying the required system power. This enables the battery pack to complete a full charging or discharging process, so as to obtain a currently available capacity of the battery pack accurately and implement precise calculation of the SOH value. This technical solution can solve the problem of an decline in the SOH detection precision caused by the OCV-SOC relation curve changed after the aging of the battery pack.

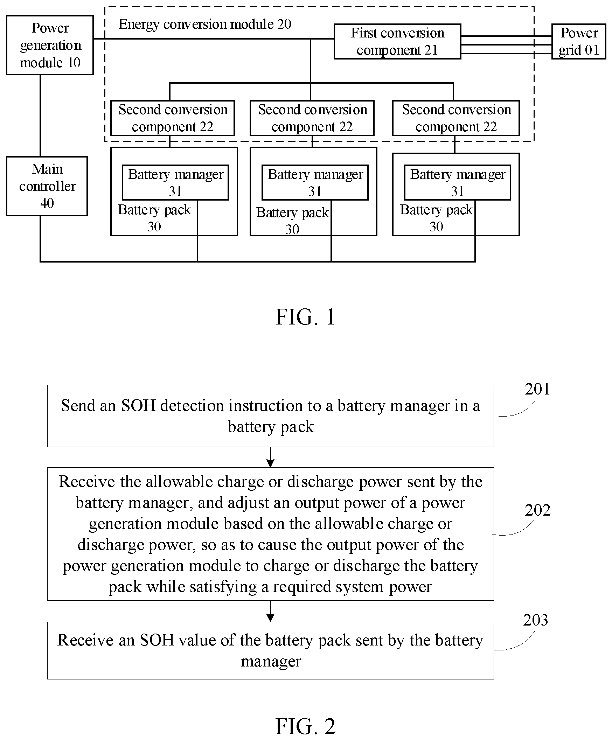

FIG. 1 is a schematic structural diagram of an energy storage system according to an embodiment of this application. As shown in FIG. 1, the energy storage system may include a power generation module 10, an energy conversion module 20, a battery pack 30, and a main controller 40.

Optionally, the power generation module 10 may include a photovoltaic power generation module, a wind power generation module, a hydropower generation module, a thermal power generation module, or the like. For example, the power generation module 10 may include a photovoltaic power generation module. The photovoltaic power generation module may include a photovoltaic module and a photovoltaic inverter that contains a maximum power point tracking (maximum power point tracking, MPPT) unit. The photovoltaic module is configured to convert solar energy into electrical energy. The photovoltaic inverter is configured to monitor a power generation voltage of the photovoltaic module and track the highest voltage and current value, so as to transmit a maximum power to the energy conversion module 20.

The energy conversion module 20 is connected to the power generation module 10 and the battery pack 30. The energy conversion module 20 is configured to convert electrical energy generated by the power generation module 10, so as to charge the battery pack 30 and/or supply power to an external device, or is configured to convert electrical energy provided by the battery pack 30, so as to supply power to an external device. The supplying power to an external device may mean supplying power to an external power grid 01 or an external load. The power grid 01 may be used as a power supplementing and absorbing apparatus.

The energy conversion module 20 may include: a first conversion component 21 and a plurality of second conversion components 22. One end of the first conversion component 21 is connected to the power generation module 10, and another end of the first conversion component 21 is connected to the power grid 01. The first conversion component 21 may be a bidirectional direct current/alternating current (direct current/alternating current, DC/AC) component. The bidirectional AC/DC component needs to support a function of fast switching between charge or discharge.

Referring to FIG. 1, the energy storage system may include a plurality of battery packs 30 connected in parallel (FIG. 1 shows three battery packs 30). Each battery pack 30 may include a battery manager 31. One end of the plurality of second conversion components 22 is connected to the plurality of battery packs 30 in a one-to-one correspondence. Another end of the plurality of second conversion components 22 is connected to one end of the first conversion component 21.

The second conversion component 22 may be a bidirectional DC-DC component. The bidirectional DC-DC component needs to support the function of fast switching between charge or discharge and satisfy the charge or discharge power required by the battery pack 30. The bidirectional DC-DC component may be an isolated component or a non-isolated component.

The first conversion component 21 is configured to convert the generated electrical energy of the power generation module 10 into the power required by the power grid 01, thereby enabling the power generation module 10 to supply power to the power grid 01. The first conversion component 21 and the plurality of second conversion components 22 are further configured to convert the electrical energy provided by the battery pack 30 into the power required by the power grid 01, thereby enabling the battery pack 20 to supply power to the power grid 01. Each second conversion component 22 is further configured to convert the generated electrical energy of the power generation module 10 into a charge power required by one corresponding battery pack 20, thereby enabling the power generation module 10 to charge the battery pack 30.

The main controller 40 is configured to send an SOH detection instruction to the battery manager 31 in the battery pack 30. The battery manager 31 is configured to determine an allowable charge or discharge power of the battery pack 30 upon receiving the SOH detection instruction, and send the allowable charge or discharge power to the main controller.

The main controller 40 is further configured to adjust a current output power of the power generation module 10 based on the allowable charge or discharge power, so that when converted by the energy conversion module 20, the current output power of the power generation module 10 satisfies a required system power for supplying power to an external device and an allowable charge or discharge power for charging or discharging the battery pack 30. The battery manager 31 is further configured to determine an available capacity of the battery pack 30 upon completion of charging or discharging the battery pack 30, calculate an SOH value of the battery pack based on the available capacity, and send the SOH value of the battery pack to the main controller 40.

FIG. 2 is a flowchart of an SOH detection method according to an embodiment of this application. This method is applicable to the main controller 40 of the energy storage system shown in FIG. 1. As shown in FIG. 2, the method includes the following steps:

Step 201: Send an SOH detection instruction to a battery manager in a battery pack.

The main controller may send an SOH detection instruction to the battery manager in the battery pack. The SOH detection instruction is used for instructing the battery manager to determine an allowable charge or discharge power of the battery pack. The battery manager can determine an allowable charge or discharge power of the battery pack upon receiving the SOH detection instruction, and send the allowable charge or discharge power to the main controller.

Step 202: Receive the allowable charge or discharge power sent by the battery manager, and adjust an output power of a power generation module based on the allowable charge or discharge power, so as to cause the output power of the power generation module to charge or discharge the battery pack while satisfying a required system power.

Upon receiving the allowable charge or discharge power sent by the battery manager, the main controller may adjust the output power of the power generation module based on the allowable charge or discharge power, so as to cause the output power of the power generation module to charge or discharge the battery pack while satisfying the required system power.

Step 203: Receive an SOH value of the battery pack sent by the battery manager.

The battery manager can determine an available capacity of the battery pack upon completion of charging or discharging the battery pack, calculate an SOH value of the battery pack based on the available capacity, and send the SOH value of the battery pack to the main controller. The corresponding main controller can receive the SOH value of the battery pack.

To sum up, this embodiment of this application provides an SOH detection method. In this method, the main controller can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH value.

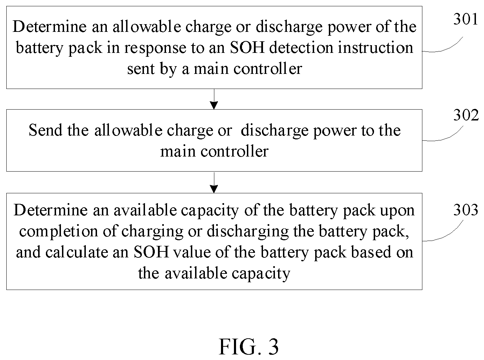

FIG. 3 is a flowchart of another SOH detection method according to an embodiment of this application. This method is applicable to the battery manager 31 of the battery pack 30 in the energy storage system shown in FIG. 1. As shown in FIG. 3, the method includes the following steps:
Step 301: Determine an allowable charge or discharge power of the battery pack in response to an SOH detection instruction sent by a main controller.

The battery manager can determine the allowable charge or discharge power of the battery pack in response to the SOH detection instruction sent by the main controller. The SOH detection instruction is generated by the main controller when it is determined that the energy storage system satisfies SOH detection conditions.

Step 302: Send the allowable charge or discharge power to the main controller.

Upon determining the allowable charge or discharge power, the battery manager may send the allowable charge or discharge power to the main controller, so as to instruct the main controller to adjust an output power of a power generation module in the energy storage system based on the allowable charge or discharge power, thereby causing the output power of the power generation module to charge or discharge the battery pack while satisfying the required system power.

Step 303: Determine an available capacity of the battery pack upon completion of charging or discharging the battery pack, and calculate an SOH value of the battery pack based on the available capacity.

The battery manager determines an available capacity of the battery pack upon completion of charging or discharging the battery pack, and calculates an SOH value of the battery pack based on the available capacity.

To sum up, this embodiment of this application provides an SOH detection method. In this method, the battery manager sends the allowable charge or discharge power to the main controller, thereby instructing the main controller to adjust the output power of the power generation module based on the allowable charge or discharge power. In this way, the output power of the power generation module charges or discharges the battery pack while satisfying the required system power. This enables the battery pack to complete a full charging or discharging process, so that the battery manager can obtain a currently available capacity of the battery pack accurately and implement precise calculation of the SOH value.

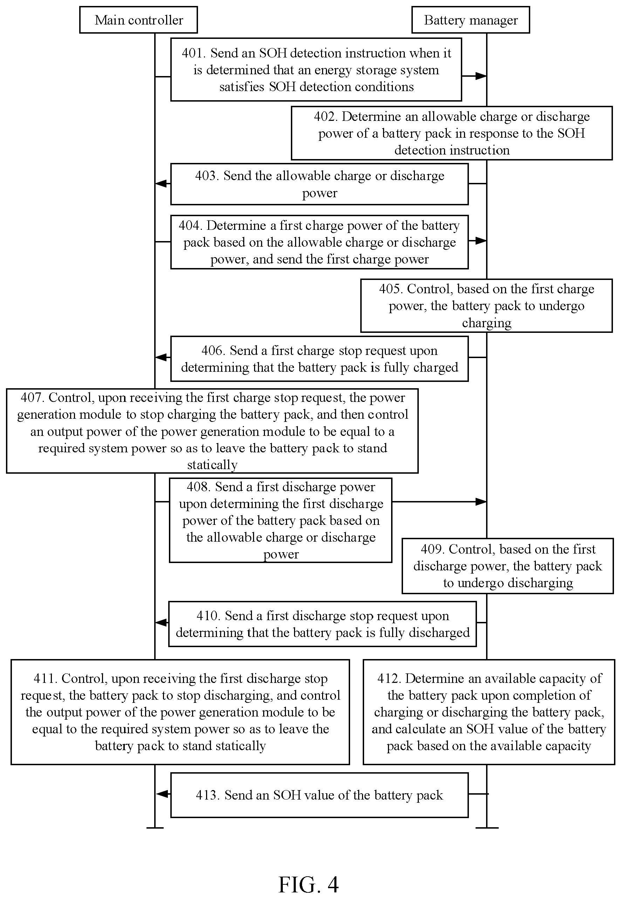

FIG. 4 is a flowchart of still another SOH detection method according to an embodiment of this application. This method is applicable to a main controller 40 and a battery manager 31 of the battery pack 30 in the energy storage system shown in FIG. 1. As shown in FIG. 4, the method may include the following steps:

Step 401: A main controller sends an SOH detection instruction to a battery manager when it is determined that an energy storage system satisfies SOH detection conditions.

The main controller detects, at intervals of a detection duration, whether the energy storage system satisfies the SOH detection conditions, and sends an SOH detection instruction to the battery manager when determining that the energy storage system satisfies the SOH detection conditions. When it is determined that the energy storage system does not satisfy the SOH detection conditions, no SOH detection instruction needs to be sent to the battery manager. The detection duration may be a fixed duration pre-stored in the main controller.

In this embodiment of this application, if the main controller determines that the output power of the power generation module is greater than the required system power, and the duration in which the output power of the power generation module is greater than the required system power is greater than or equal to the preset SOH detection duration, it is determined that the energy storage system satisfies the SOH detection conditions. The required system power means a power currently required by an external power grid or load. The preset SOH detection duration may be a fixed duration pre-stored in the main controller. The preset SOH detection duration means a duration required for performing SOH detection for the battery pack. The output power of the power generation module means a current output power of the power generation module. The required system power means a currently required power of the system.

If the output power of the power generation module is less than or equal to the required system power, or, if the output power of the power generation module is greater than the required system power but the duration in which the output power of the power generation module is greater than the required system power is less than the preset SOH detection duration, then it is determined that the energy storage system does not satisfy the SOH detection conditions.

Understandably, the power generation module needs to supply power to the power grid and the battery pack simultaneously during the SOH detection. Therefore, the SOH detection is performed when the output power of the power generation module is greater than the required system power and the duration of this state is greater than or equal to the preset SOH detection duration, thereby ensuring that the SOH can be detected reliably while the power generation module can supply power to the power grid normally.

In this embodiment of this application, the main controller can predict, based on the following parameters, whether the output power of the power generation module in a second time period is greater than the required system power in the second time period, and whether the duration of this state is greater than or equal to the preset SOH detection duration, where the parameters are: the output power of the power generation module in a first time period, the required system power in the first time period, actual meteorological data in the first time period in the region in which the energy storage system is located, predicted meteorological data of this region in the second time period predicted by the meteorological source, and grid dispatch parameters in the second time period. If the output power of the power generation module in the second time period is greater than the required system power in the second time period, and, if the duration of this state is greater than or equal to the preset SOH detection duration, then the main controller determines that the SOH detection can be performed in the second time period. Therefore, the main controller may send an SOH detection instruction to the battery manager upon arrival of the second time period, thereby ensuring the feasibility of the SOH detection.

The actual meteorological data and the predicted meteorological data may include at least one of irradiance, temperature, rainfall, light intensity, light duration, cloud cover, clear sky index, and weather type. The grid dispatch parameters may include power grid dispatch power, grid dispatch duration, and the like. The second time period comes after the first time period.

Step 402: The battery manager determines the allowable charge or discharge power of the battery pack in response to the SOH detection instruction.

Upon receiving the SOH detection instruction sent by the main controller, the battery manager may determine the allowable charge or discharge power of the battery pack in response to the SOH detection instruction.

The battery manager may determine the allowable charge or discharge power of the battery pack based on the SOC value of the battery pack. The allowable charge or discharge power may mean, for example, a maximum charge power that the battery pack can receive in a case of charging the battery pack, and/or a maximum discharge power of the battery pack in a case of discharging the battery pack.

Step 403: The battery manager sends the allowable charge or discharge power to the main controller.

Upon determining the allowable charge or discharge power of the battery pack, the battery manager may send the allowable charge or discharge power to the main controller. Accordingly, the main controller may receive the allowable charge or discharge power sent by the battery manager.

Step 404: The main controller determines a first charge power of the battery pack based on the allowable charge or discharge power, and sends the first charge power to the battery manager.

Upon receiving the allowable charge or discharge power sent by the battery manager, the main controller may adjust the output power of the power generation module based on the allowable charge or discharge power, so as to cause the output power of the power generation module to charge or discharge the battery pack while satisfying the required system power.

In this embodiment of this application, the main controller may determine the first charge power of the battery pack based on the allowable charge or discharge power, and send the first charge power to the battery manager. The first charge power is equal to a difference between the output power of the power generation module and the required system power. The first charge power is less than or equal to a maximum charge power among the allowable charge or discharge powers.

Optionally, the main controller may, by adjusting the output power of the power generation module, make the output power of the power generation module be greater than the required system power, so as to be able to charge the battery pack based on the first charge power.

As an example, if the output power of the power generation module is less than or equal to the required system power, the main controller may increase the output power of the power generation module to make the output power of the power generation module be greater than the required system power.

Step 405: Based on the first charge power, the battery manager controls the battery pack to undergo charging.

Upon receiving the first charge power sent by the main controller, the battery manager may control, based on the first charge power, the battery pack to undergo charging, thereby enabling the power generation module to charge the battery pack.

Step 406: The battery manager sends a first charge stop request to the main controller upon determining that the battery pack is fully charged.

In a process of controlling, based on the first charge power, the battery pack to undergo charging, the battery manager may periodically detect whether the battery pack is fully charged, and send a first charge stop request to the main controller upon determining that the battery pack is fully charged. The first charge stop request is used for instructing the main controller to control the power generation module to stop charging the battery pack, and then control the output power of the power generation module to be equal to the required system power so as to leave the battery pack to stand statically.

Optionally, in a process of controlling, based on the first charge power, the battery pack to undergo charging, the battery manager may detect whether the voltage of the battery pack reaches a full-charge cut-off voltage. If the voltage of the battery pack reaches the full-charge cut-off voltage, it is determined that the battery pack is fully charged. If the voltage of the battery pack does not reach the full-charge cut-off voltage, it is determined that the battery pack is not fully charged. The full-charge cut-off voltage of the battery pack may be pre-stored in the battery manager.

Step 407: Upon receiving the first charge stop request, the main controller controls the power generation module to stop charging the battery pack, and then controls the output power of the power generation module to be equal to the required system power so as to leave the battery pack to stand statically.

Upon receiving the first charge stop request sent by the battery manager, the main controller determines that the battery pack is fully charged, and therefore, may control the power generation module to stop charging the battery pack. Subsequently, after controlling the power generation module to stop charging the battery pack, the main controller may adjust the output power of the power generation module to make the output power of the power generation module be equal to the required system power so as to leave the battery pack to stand statically.

Optionally, if the output power of the power generation module is greater than the required system power, the main controller may decrease the output power of the power generation module to make the output power of the power generation module be equal to the required system power.

During static standing of the battery pack, the battery pack is not charged or discharged, thereby eliminating the polarization phenomenon caused by the charging of the battery pack, and in turn, ensuring the accuracy of the battery manager in determining the available capacity of the battery pack. Therefore, during static standing of the battery pack, the main controller may control the power generation module to curtail the output power, so that the output power of the power generation module satisfies the required system power. In other words, the output power of the power generation module can be controlled to be equal to the required system power.

Step 408: The main controller sends a first discharge power to the battery manager upon determining the first discharge power of the battery pack based on the allowable charge or discharge power.

After controlling the power generation module to complete one full-charge process of the battery pack, the main controller may further control the battery pack to complete one full-discharge process. Therefore, after controlling the output power of the power generation module to be equal to the required system power, the main controller may further determine a first discharge power of the battery pack based on the allowable charge or discharge power, and send the first discharge power to the battery manager. The first discharge power is equal to a difference between the required system power and the output power of the power generation module. The first discharge power is less than or equal to a maximum discharge power among the allowable charge or discharge powers.

Optionally, the main controller may adjust the output power of the power generation module to make the required system power be greater than the output power of the power generation module. In this way, the battery manager can control, based on the first discharge power, the battery pack to undergo discharging, so as to enable the battery pack to supply power to the power grid.

Step 409: Based on the first discharge power, the battery manager controls the battery pack to undergo discharging.

Upon receiving the first discharge power sent by the main controller, the battery manager may control, based on the first discharge power, the battery pack to undergo discharging, thereby enabling the battery pack to supply power to the power grid.

Step 410: The battery manager sends a first discharge stop request to the main controller upon determining that the battery pack is fully discharged.

In a process of controlling, based on the first discharge power, the battery pack to undergo discharging, the battery manager may periodically detect whether the battery pack is fully discharged, and send a first discharge stop request to the main controller upon determining that the battery pack is fully discharged. The first discharge stop request is used for instructing the main controller to control the battery pack to stop discharging, and control the output power of the power generation module to be equal to the required system power so as to leave the battery pack to stand statically.

Optionally, in a process of controlling, based on the first discharge power, the battery pack to undergo discharging, the battery manager may detect whether the voltage of the battery pack reaches a full-discharge cut-off voltage. If the voltage of the battery pack reaches the full-discharge cut-off voltage, it is determined that the battery pack is fully discharged. If the voltage of the battery pack does not reach the full-discharge cut-off voltage, it is determined that the battery pack is not fully discharged. The full-discharge cut-off voltage of the battery pack may be pre-stored in the battery manager.

Step 411: Upon receiving the first discharge stop request, the main controller controls the battery pack to stop discharging, and controls the output power of the power generation module to be equal to the required system power so as to leave the battery pack to stand statically.

Upon receiving a first discharge stop request sent by the battery manager, the main controller may control the battery pack to stop discharging. After controlling the battery pack to stop discharging, the main controller may adjust the output power of the power generation module to make the output power of the power generation module be equal to the required system power so as to leave the battery pack to stand statically.

Optionally, if the output power of the power generation module is less than the required system power, the main controller may increase the output power of the power generation module to make the output power of the power generation module be equal to the required system power.

During static standing of the battery pack, the battery pack is not charged or discharged, thereby eliminating the polarization phenomenon caused by the discharging of the battery pack, and in turn, ensuring the accuracy of the battery manager in determining the available capacity of the battery pack. Therefore, during static standing of the battery pack, the main controller just needs to control the output power of the power generation module to satisfy the required system power.

Step 412: The battery manager determines an available capacity of the battery pack upon completion of charging or discharging the battery pack, and calculates an SOH value of the battery pack based on the available capacity.

Upon completion of charging or discharging the battery pack, that is, upon completion of one full charge or one full discharge of the battery pack, the battery manager may determine an available capacity of the battery pack, and may calculate an SOH value of the battery pack based on the available capacity.

Optionally, the battery manager may determine the SOH value of the battery pack based on the available capacity and a nominal capacity. The nominal capacity is pre-stored in the battery manager. For example, the battery manager may determine that a ratio of the available capacity to the nominal capacity is the SOH value of the battery pack.

Step 413: The battery manager sends the SOH value of the battery pack to the main controller.

After determining the SOH value of the battery pack, the battery manager may send the SOH value of the battery pack to the main controller. Accordingly, the main controller may receive the SOH value of the battery pack. In this way, the main controller can accurately determine the aging degree of the battery pack based on the received SOH value.

To sum up, this embodiment of this application provides an SOH detection method. In this method, the main controller can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

In addition, the static standing undergone by the battery pack after completion of charging and after completion of discharging can eliminate the polarization phenomenon caused by the discharging and charging of the battery pack, thereby obtaining the currently available capacity of the battery pack accurately and implementing precise calculation of the SOH value. This effectively solves the problem of a decline in the SOH detection precision caused by the OCV-SOC relation curve changed after the aging of the battery pack, provides accurate data for the use of an energy storage battery for 20 to 25 years, and plays a significant role in the algorithm and strategies of a battery management system.

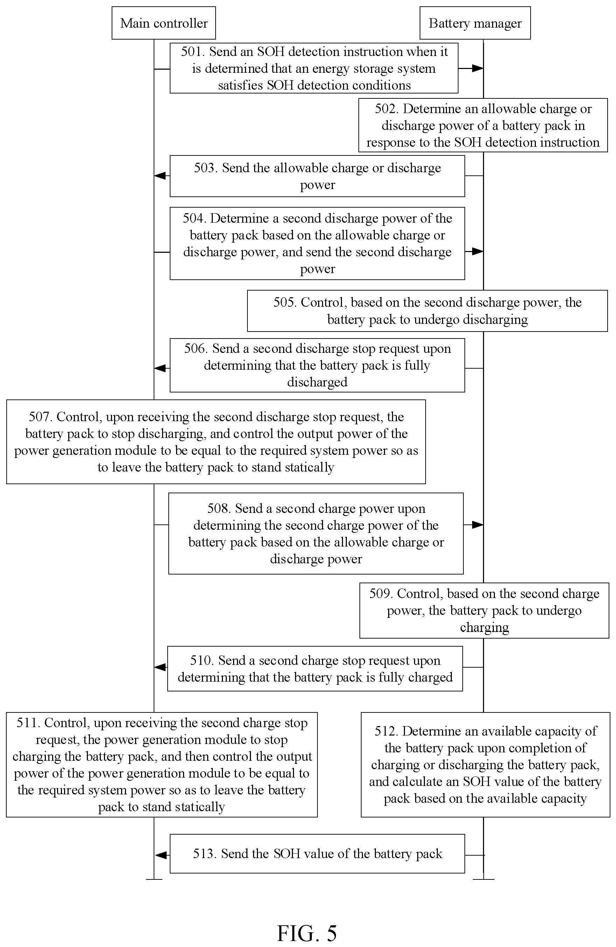

FIG. 5 is a flowchart of yet another SOH detection method according to an embodiment of this application. This method is applicable to a main controller 40 and a battery manager 31 of the battery pack 30 in the energy storage system shown in FIG. 1. As shown in FIG. 5, the method may include the following steps:

Step 501: A main controller sends an SOH detection instruction to a battery manager when it is determined that an energy storage system satisfies SOH detection conditions.

The specific implementation process of step 501 may be learned with reference to step 401 above, the details of which are omitted here.

Step 502: The battery manager determines the allowable charge or discharge power of the battery pack in response to the SOH detection instruction.

The specific implementation process of step 502 may be learned with reference to step 402 above, the details of which are omitted here.

Step 503: The battery manager sends the allowable charge or discharge power to the main controller.

The specific implementation process of step 503 may be learned with reference to step 403 above, the details of which are omitted here.

Step 504: The main controller determines a second discharge power of the battery pack based on the allowable charge or discharge power, and sends the second discharge power to the battery manager.

Upon receiving the allowable charge or discharge power sent by the battery manager, the main controller may adjust the output power of the power generation module based on the allowable charge or discharge power, so as to cause the output power of the power generation module to charge or discharge the battery pack while satisfying the required system power.

In this embodiment of this application, the main controller may determine the second discharge power of the battery pack based on the allowable charge or discharge power, and send the second discharge power to the battery manager. The second discharge power is equal to a difference between the required system power and the output power of the power generation module. The second discharge power is less than or equal to a maximum discharge power among the allowable charge or discharge powers.

Optionally, the main controller may adjust the output power of the power generation module to make the output power of the power generation module be less than the required system power. In this way, the battery manager can control, based on the second discharge power, the battery pack to undergo discharging, so as to enable the battery pack to supply power to the power grid.

As an example, if the output power of the power generation module is greater than or equal to the required system power, the main controller may decrease the output power of the power generation module to make the output power of the power generation module be less than the required system power.

Step 505: Based on the second discharge power, the battery manager controls the battery pack to undergo discharging.

Upon receiving the second discharge power sent by the main controller, the battery manager may control, based on the second discharge power, the battery pack to undergo discharging, thereby enabling the battery pack to supply power to the power grid.

Step 506: The battery manager sends a second discharge stop request to the main controller upon determining that the battery pack is fully discharged.

In a process of controlling, based on the second discharge power, the battery pack to undergo discharging, the battery manager may periodically detect whether the battery pack is fully discharged, and send a second discharge stop request to the main controller upon determining that the battery pack is fully discharged. The second discharge stop request is used for instructing the main controller to control the battery pack to stop discharging, and control the output power of the power generation module to be equal to the required system power so as to leave the battery pack to stand statically.

Optionally, in a process of controlling, based on the second discharge power, the battery pack to undergo discharging, the battery manager may detect whether the voltage of the battery pack reaches a full-discharge cut-off voltage. If the voltage of the battery pack reaches the full-discharge cut-off voltage, it is determined that the battery pack is fully discharged. If the voltage of the battery pack does not reach the full-discharge cut-off voltage, it is determined that the battery pack is not fully discharged. The full-discharge cut-off voltage of the battery pack may be pre-stored in the battery manager.

Step 507: Upon receiving the second discharge stop request, the main controller controls the battery pack to stop discharging, and controls the output power of the power generation module to be equal to the required system power so as to leave the battery pack to stand statically.

Upon receiving the second discharge stop request, the main controller may control the battery pack to stop discharging. After controlling the battery pack to stop discharging, the main controller may adjust the output power of the power generation module to make the output power of the power generation module be equal to the required system power so as to leave the battery pack to stand statically.

Optionally, if the output power of the power generation module is less than the required system power, the main controller may increase the output power of the power generation module to make the output power of the power generation module be equal to the required system power.

During static standing of the battery pack, the battery pack is not charged or discharged, thereby eliminating the polarization phenomenon caused by the discharging of the battery pack, and in turn, ensuring the accuracy of determining the capacity of the battery pack. Therefore, during static standing of the battery pack, the main controller just needs to control the output power of the power generation module to satisfy the required system power.

Step 508: The main controller sends a second charge power to the battery manager upon determining the second charge power of the battery pack based on the allowable charge or discharge power.

After controlling the power generation module to complete one full-discharge process of the battery pack, the main controller may further control the battery pack to complete one full-charge process. Therefore, after controlling the output power of the power generation module to be equal to the required system power, the main controller may further determine a second charge power of the battery pack based on the allowable charge or discharge power, and send the second charge power to the battery manager.

The second charge power is equal to a difference between the output power of the power generation module and the required system power. The second charge power is less than or equal to a maximum charge power among the allowable charge or discharge powers.

Optionally, the main controller may, by adjusting the output power of the power generation module, make the output power of the power generation module be greater than the required system power, so as to be able to charge the battery pack based on the second charge power.

As an example, if the output power of the power generation module is less than or equal to the required system power, the main controller may increase the output power of the power generation module to make the output power of the power generation module be greater than the required system power.

Step 509: Based on the second charge power, the battery manager controls the battery pack to undergo charging.

Upon receiving the second charge power sent by the main controller, the battery manager may control, based on the second charge power, the battery pack to undergo charging, thereby enabling the power generation module to charge the battery pack.

Step 510: The battery manager sends a second charge stop request to the main controller upon determining that the battery pack is fully charged.

In a process of controlling, based on the second charge power, the battery pack to undergo charging, the battery manager may periodically detect whether the battery pack is fully charged, and send a second charge stop request to the main controller upon determining that the battery pack is fully charged. The second charge stop request is used for instructing the main controller to control the power generation module to stop charging the battery pack, and then control the output power of the power generation module to be equal to the required system power so as to leave the battery pack to stand statically.

Optionally, in a process of controlling, based on the second charge power, the battery pack to undergo charging, the battery manager may detect whether the voltage of the battery pack reaches a full-charge cut-off voltage. If the voltage of the battery pack reaches the full-charge cut-off voltage, it is determined that the battery pack is fully charged. If the voltage of the battery pack does not reach the full-charge cut-off voltage, it is determined that the battery pack is not fully charged. The full-charge cut-off voltage of the battery pack may be pre-stored in the battery manager.

Step 511: Upon receiving the second charge stop request, the main controller controls the power generation module to stop charging the battery pack, and then controls the output power of the power generation module to be equal to the required system power so as to leave the battery pack to stand statically.

Upon receiving the second charge stop request sent by the battery manager, the main controller determines that the battery pack is fully charged, and therefore, may control the power generation module to stop charging the battery pack. Subsequently, after controlling the power generation module to stop charging the battery pack, the main controller may adjust the output power of the power generation module to make the output power of the power generation module be equal to the required system power so as to leave the battery pack to stand statically.

Optionally, if the output power of the power generation module is greater than the required system power, the main controller may decrease the output power of the power generation module to make the output power of the power generation module be equal to the required system power.

During static standing of the battery pack, the battery pack is not charged or discharged, thereby eliminating the polarization phenomenon caused by the charging of the battery pack, and in turn, ensuring the accuracy of the battery manager in determining the available capacity of the battery pack. Therefore, during static standing of the battery pack, the main controller may control the power generation module to curtail the output power, so that the output power of the power generation module satisfies the required system power. In other words, the output power of the power generation module can be controlled to be equal to the required system power.

Step 512: The battery manager determines an available capacity of the battery pack upon completion of charging or discharging the battery pack, and calculates an SOH value of the battery pack based on the available capacity.

The specific implementation method of step 512 may be learned with reference to step 412 above, the details of which are omitted here.

Step 513: The battery manager sends the SOH value of the battery pack to the main controller.

The specific implementation method of step 513 may be learned with reference to step 413 above, the details of which are omitted here.

To sum up, this embodiment of this application provides an SOH detection method. In this method, the main controller can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

In addition, the static standing undergone by the battery pack after completion of charging and after completion of discharging can eliminate the polarization phenomenon caused by the discharging and charging of the battery pack, thereby obtaining the currently available capacity of the battery pack accurately and implementing precise calculation of the SOH value. This effectively solves the problem of a decline in the SOH detection precision caused by the OCV-SOC relation curve changed after the aging of the battery pack, provides accurate data for the use of an energy storage battery for 20 to 25 years, and plays a significant role in the algorithm and strategies of a battery management system.

An embodiment of this application provides a computer-readable storage medium. The computer-readable storage medium stores a computer program. When executed by a computer device, the computer program causes the computer device to implement the SOH detection method shown in any one of FIG. 2 to FIG. 5.

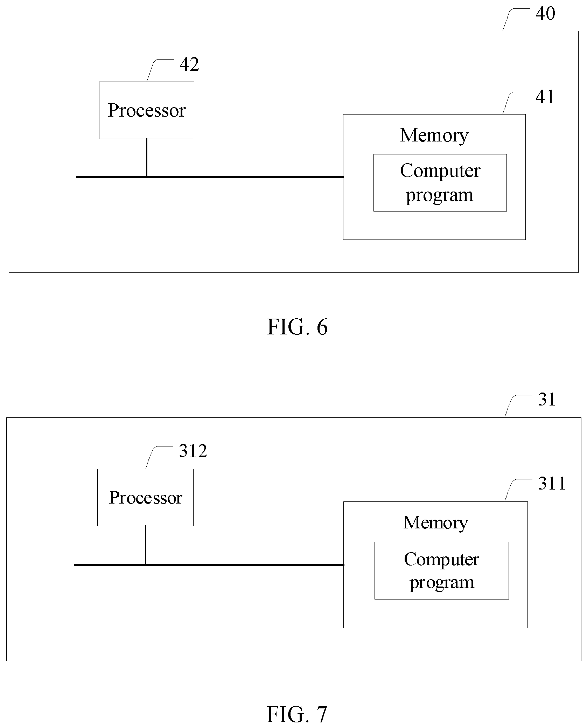

FIG. 6 is a schematic structural diagram of a main controller 40 in an energy storage system according to an embodiment of this application. As shown in FIG. 6, the main controller 40 includes a memory 41 and a processor 42. The memory 41 stores a computer program. When executed by the processor 42, the computer program causes the main controller 40 to implement the SOH detection method shown in any one of FIG. 2, FIG. 4, or FIG. 5.

FIG. 7 is a schematic structural diagram of a battery manager 31 of a battery pack in an energy storage battery according to an embodiment of this application. The battery manager includes a memory 311 and a processor 312. The memory 311 stores a computer program. When executed by the processor 312, the computer program causes the battery manager 31 to implement the SOH detection method shown in FIG. 3 to FIG. 4.

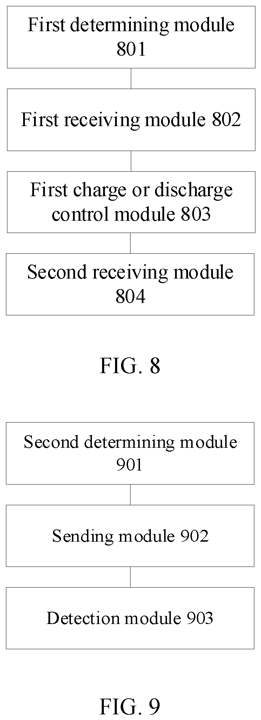

FIG. 8 is a block diagram of an SOH detection apparatus according to an embodiment of this application. The apparatus is applicable to a main controller 40 of the energy storage system shown in FIG. 1. As shown in FIG. 8, the apparatus includes:
a first determining module 801, configured to send an SOH detection instruction to a battery manager of a battery pack in the energy storage system, where the SOH detection instruction is used for instructing the battery manager to determine an allowable charge or discharge power of the battery pack;
a first receiving module 802, configured to receive an allowable charge or discharge power sent by the battery manager;
a first charge or discharge control module 803, configured to adjust an output power of a power generation module in the energy storage system based on the allowable charge or discharge power, so as to cause the output power of the power generation module to charge or discharge the battery pack while satisfying a required system power; and
a second receiving module 804, configured to receive the SOH value of the battery pack sent by the battery manager, where the SOH value of the battery pack is determined after completion of charging or discharging the battery pack.

Optionally, the first charge or discharge control module 803 is configured to:
send a first charge power of the battery pack determined based on the allowable charge or discharge power to the battery manager, so as to instruct the battery manager to control, based on the first charge power, the battery pack to undergo charging, where the first charge power is equal to a difference between the output power of the power generation module and the required system power;
control, upon receiving a first charge stop request sent by the battery manager, the power generation module to stop charging the battery pack;
send a first discharge power of the battery pack determined based on the allowable charge or discharge power to the battery manager, so as to instruct the battery manager to control, based on the first discharge power, the battery pack to undergo discharging, where the first discharge power is equal to a difference between the required system power and the output power of the power generation module; and
control, upon receiving a first discharge stop request sent by the battery manager, the battery pack to stop discharging.

Optionally, the first charge or discharge control module 803 is further configured to: control, after controlling the power generation module to stop charging the battery pack, the output power of the power generation module to be equal to the required system power so as to leave the battery pack to stand statically.

Optionally, the first charge or discharge control module 803 is further configured to: control, after controlling the battery pack to stop discharging, the output power of the power generation module to be equal to the required system power so as to leave the battery pack to stand statically.

Optionally, the first charge or discharge control module 803 is configured to:
send a second discharge power of the battery pack determined based on the allowable charge or discharge power to the battery manager, so as to instruct the battery manager to control, based on the second discharge power, the battery pack to undergo discharging, where the second discharge power is equal to a difference between the required system power and the output power of the power generation module;
control, upon receiving a second discharge stop request sent by the battery manager, the battery pack to stop discharging;
send a second charge power of the battery pack determined based on the allowable charge or discharge power to the battery manager, so as to instruct the battery manager to control, based on the second charge power, the battery pack to undergo charging, where the second charge power is equal to a difference between the output power of the power generation module and the required system power; and
control, upon receiving a second charge stop request sent by the battery manager, the power generation module to stop charging the battery pack.

Optionally, the first charge or discharge control module 803 is further configured to: control, after controlling the battery pack to stop discharging, the output power of the power generation module to be equal to the required system power so as to leave the battery pack to stand statically.

Optionally, the first charge or discharge control module 803 is further configured to: control, after controlling the power generation module to stop charging the battery pack, the output power of the power generation module to be equal to the required system power so as to leave the battery pack to stand statically.

The first determining module 801 is configured to send the SOH detection instruction to the battery manager of the battery pack in the energy storage system when it is determined that the output power of the power generation module is greater than the required system power for a duration greater than or equal to a preset SOH detection duration.

To sum up, this embodiment of this application provides an SOH detection apparatus. The main controller in the apparatus can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

FIG. 9 is a block diagram of another SOH detection apparatus according to an embodiment of this application. The apparatus is applicable to a battery manager 31 of a battery pack in the energy storage system shown in FIG. 1. As shown in FIG. 9, the apparatus includes:
a second determining module 901, configured to determine an allowable charge or discharge power of the battery pack in response to an SOH detection instruction sent by a main controller of the energy storage system;
a sending module 902, configured to send the allowable charge or discharge power to the main controller, so that the main controller adjusts an output power of a power generation module in the energy storage system based on the allowable charge or discharge power, so as to cause the output power of the power generation module to charge or discharge the battery pack while satisfying a required system power; and
a detection module 903, configured to determine an available capacity of the battery pack upon completion of charging or discharging the battery pack, and calculate an SOH value of the battery pack based on the available capacity.

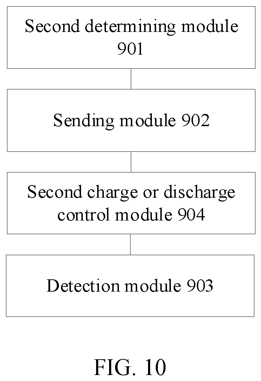

Optionally, as shown in FIG. 10, the apparatus may further include a second charge or discharge control module 904, configured to:
control, based on a first charge power sent by the main controller, the battery pack to undergo charging, where the first charge power is equal to a difference between the output power of the power generation module and the required system power;
send, upon determining that the battery pack is fully charged, a first charge stop request to the main controller, so as to instruct the main controller to control the power generation module to stop charging the battery pack;
control, based on a first discharge power sent by the main controller, the battery pack to undergo discharging, where the first discharge power is equal to a difference between the required system power and the output power of the power generation module; and
send a first discharge stop request to the main controller upon determining that the battery pack is fully discharged, so as to instruct the main controller to control the battery pack to stop discharging.

Optionally, the first charge stop request is further used for instructing the main controller to control, after controlling the power generation module to stop charging the battery pack, the output power of the power generation module to be equal to the required system power so as to leave the battery pack to stand statically.

Optionally, the first discharge stop request is further used for instructing the main controller to control, after controlling the battery pack to stop discharging, the output power of the power generation module to be equal to the required system power so as to leave the battery pack to stand statically.

Optionally, as shown in FIG. 10, the second charge or discharge control module 904 is configured to:
control, based on a second discharge power sent by the main controller, the battery pack to undergo discharging, where the second discharge power is equal to a difference between the required system power and the output power of the power generation module;
send a second discharge stop request to the main controller upon determining that the battery pack is fully discharged, so as to instruct the main controller to control the battery pack to stop discharging;
control, based on a second charge power sent by the main controller, the battery pack to undergo charging, where the second charge power is equal to a difference between the output power of the power generation module and the required system power; and
send, upon determining that the battery pack is fully charged, a second charge stop request to the main controller, so as to instruct the main controller to control the power generation module to stop charging the battery pack.

Optionally, the second charge stop request is further used for instructing the main controller to control, after controlling the power generation module to stop charging the battery pack, the output power of the power generation module to be equal to the required system power so as to leave the battery pack to stand statically.

Optionally, the second discharge stop request is further used for instructing the main controller to control, after controlling the battery pack to stop discharging, the output power of the power generation module to be equal to the required system power so as to leave the battery pack to stand statically.

Optionally, the SOH detection instruction is sent by the main controller when determining that the output power of the power generation module is greater than the required system power for a duration greater than or equal to a preset SOH detection duration.

To sum up, this embodiment of this application provides an SOH detection apparatus. In this apparatus, the battery manager sends the allowable charge or discharge power to the main controller, thereby instructing the main controller to adjust the output power of the power generation module based on the allowable charge or discharge power. In this way, the output power of the power generation module charges or discharges the battery pack while satisfying the required system power, thereby enabling the battery pack to complete a full charging or discharging process. In this way, the battery manager can obtain the currently available capacity of the battery pack accurately and implement precise calculation of the SOH value.

Referring to FIG. 1, the main controller 40 in the energy storage system according to this embodiment of this application is further configured to send an allowable charge or discharge power to the battery manager 31, where the first charge power is equal to a difference between the output power of the power generation module and the required system power;

The battery manager 31 is further configured to control, based on the first charge power, the battery pack to undergo charging, and send a first charge stop request to the main controller 40 upon determining that the battery pack is fully charged.

The main controller 40 is further configured to: control, upon receiving a first charge stop request sent by the battery manager 31, the power generation module to stop charging the battery pack; and send a first discharge power to the battery manager 31 upon determining the first discharge power of the battery pack based on the allowable charge or discharge power, where the first discharge power is equal to a difference between the required system power and the output power of the power generation module.

The battery manager 31 is further configured to control, based on the first discharge power, the battery pack to undergo discharging, and send a first discharge stop request to the main controller 40 upon determining that the battery pack is fully discharged.

The main controller 40 is further configured to: control, upon receiving the first discharge stop request sent by the battery manager 31, the battery pack to stop discharging.

Referring to FIG. 1, the main controller 40 is further configured to control, after controlling the power generation module to stop charging the battery pack, the output power of the power generation module to be equal to the required system power so as to leave the battery pack to stand statically.

Referring to FIG. 1, the main controller 40 is further configured to control, after controlling the battery pack to stop discharging, the output power of the power generation module to be equal to the required system power so as to leave the battery pack to stand statically.

Referring to FIG. 1, the main controller 40 is further configured to determine a second discharge power of the battery pack based on the allowable charge or discharge power, and send the second discharge power to the battery manager 31, where the second discharge power is equal to a difference between the required system power and the output power of the power generation module.

The battery manager 31 is further configured to control, based on the second discharge power, the battery pack to undergo discharging, and send a second discharge stop request to the main controller 40 upon determining that the battery pack is fully discharged.

The main controller 40 is further configured to control, upon receiving the second discharge stop request sent by the battery manager 31, the battery pack to stop discharging, and send a second charge power to the battery manager 31 upon determining the second charge power of the battery pack based on the allowable charge or discharge power, where the second charge power is equal to a difference between the output power of the power generation module and the required system power.

The battery manager 31 is further configured to control, based on the second charge power, the battery pack to undergo charging, and send a second charge stop request to the main controller 40 upon determining that the battery pack is fully charged.

The main controller 40 is further configured to control, upon receiving a second charge stop request sent by the battery manager 31, the power generation module to stop charging the battery pack.

Referring to FIG. 1, the main controller 40 is further configured to control, after controlling the battery pack to stop discharging, the output power of the power generation module to be equal to the required system power so as to leave the battery pack to stand statically.

Referring to FIG. 1, the main controller 40 is further configured to control, after controlling the power generation module to stop charging the battery pack, the output power of the power generation module to be equal to the required system power so as to leave the battery pack to stand statically.

Referring to FIG. 1, the main controller 40 is further configured to send the SOH detection instruction to the battery manager of the battery pack in the energy storage system when it is determined that the output power of the power generation module is greater than the required system power for a duration greater than or equal to a preset SOH detection duration.

To sum up, this embodiment of this application provides an energy storage system. In the system, the main controller can adjust an output power of a power generation module based on an allowable charge or discharge power of a battery pack, so as to cause the output power of the power generation module to charge or discharge the battery pack while satisfying a required system power. This enables the battery pack to complete a full charging or discharging process, so as to obtain a currently available capacity of the battery pack accurately and implement precise calculation of the SOH.

It is hereby noted that the logic and/or steps shown in the flowchart or otherwise described herein, for example, may be considered as a sequence of executable instructions for implementing logical functions, which may be embodied in any computer-readable medium for use by or in connection with an instruction execution system, apparatus, or device (such as a computer-based system, processor-containing system, or other systems that can fetch and execute instructions from an instruction execution system, apparatus, or device). For purposes of this specification, a "computer-readable medium" may be any apparatus that can store, communicate, propagate, or transport a program for use by or in connection with an instruction execution system, apparatus, or device. Specific examples of a computer-readable medium (a nonexhaustive list) include: an electrical connection (electronic device) containing one or more wires, a portable computer diskette (magnetic device), random access memory (RAM), read-only memory (ROM), erasable programmable read-only memory (EPROM or flash memory), fiber-optic device, and a portable compact disc read-only memory (CDROM). Further, the computer-readable medium may even be paper or another suitable medium upon which the program is printed, because the program can be captured electronically, for example, by optically scanning the paper or other media and then editing and interpreting or, when necessary, otherwise processing the paper or other media, and then can be stored in a computer memory.

Understandably, each part of this application may be implemented in hardware, software, firmware, or a combination thereof. In the embodiments described above, a plurality of steps or methods may be implemented by software or firmware stored in a memory and executed by an appropriate instruction execution system. For example, if implemented in hardware, as is the case in another embodiment, such steps or methods may be implemented by using any one of the following techniques well known in this field or a combination thereof: a discrete logic circuit containing a logic gate circuit for implementing logic functions for data signals, an application-specific integrated circuit (ASIC) containing an appropriate combinational logic gate circuit, a programmable gate array (PGA), a field-programmable gate array (FPGA), or the like.

In the context of this specification, reference to "one embodiment", "some embodiments", "one or more embodiments", "an embodiment", "specific example", "some examples", and the like means that a particular feature, structure, material, or characteristic described in connection with the embodiment or example is included in at least one embodiment or example of this application. In this embodiment, an illustrative expression of such terms do not necessarily refer to an identical embodiment or example. In addition, the particular features, structures, materials, or characteristics may be combined in one or more embodiments in any appropriate manner.

Understandably, in the description of this application, a direction or a positional relationship indicated by the terms such as "center", "longitudinal", "transverse", "length", "width", "thickness", "up", "down", "before", "after", "left", "right", "vertical", "horizontal", "top", "bottom", "in", "out", "clockwise", "counterclockwise", "axial", "radial", and "circumferential" is a direction or positional relationship based on the illustration in the drawings, and is merely intended for ease or brevity of description of this application, but not intended to indicate or imply that the mentioned device or component must be located in the specified direction or constructed or operated in the specified direction. Therefore, such terms are not intended as a limitation on this application.

In addition, the terms such as "first" and "second" used herein are merely for ease of description, but not understood to indicate or imply relative importance or implicitly specify the number of technical features mentioned in this embodiment. Therefore, features qualified by the terms such as "first" or "second" herein may explicitly or implicitly indicate that this embodiment includes at least one of the features. In the description of this application, unless otherwise expressly specified in an embodiment, the term "a plurality of" means at least two, or two or more, for example, two, three, four, or more.

In this application, unless otherwise expressly specified and defined in an embodiment, the terms such as "mount", "concatenate", "connect", and "fix" that appear in an embodiment are generic in a broad sense. For example, a connection may be a fixed connection or a detachable connection, or a one-piece configuration. Understandably, a connection may be a mechanical connection, an electrical connection, or the like; definitely, may be a direct connection or an indirect connection implemented through an intermediary; or may be internal communication between two components or an interaction relationship between two components. A person of ordinary skill in the art can understand the specific meanings of such terms in this application according to the specific context of implementation.

In this application, unless otherwise expressly specified and qualified, a first feature being "on" or "under" a second feature may be that the first feature is in direct contact with the second feature, or the first feature is in indirect contact with the second feature through an intermediary. In addition, a first feature being "on", "above", or "over" a second feature may be that the first feature is exactly above or obliquely above the second feature, or simply that the first feature is at an altitude higher than the second feature. A first feature being "under", "below", or "beneath" a second feature may be that the first feature is exactly under or obliquely under the second feature, or simply that the first feature is at an altitude lower than the second feature.

Although the embodiments of this application have been shown and described above, it is understandable that the foregoing embodiments are exemplary but not intended as a limitation on this application. A person of ordinary skill in the art may make variations, modifications, substitutions, and derivations to the embodiments without departing from the scope of this application.

## Claims

1. An SOH detection method, **characterized in that** the method is applied to a main controller of an energy storage system, and the method comprises:
sending an SOH detection instruction to a battery manager of a battery pack in the energy storage system, wherein the SOH detection instruction is used for instructing the battery manager to determine an allowable charge or discharge power of the battery pack;
receiving the allowable charge or discharge power sent by the battery manager, and adjusting an output power of a power generation module in the energy storage system based on the allowable charge or discharge power, so as to cause the output power of the power generation module to charge or discharge the battery pack while satisfying a required system power; and
receiving the SOH value of the battery pack sent by the battery manager, wherein the SOH value of the battery pack is determined after completion of charging and discharging the battery pack.

2. The SOH detection method according to claim 1, **characterized in that** the adjusting an output power of a power generation module in the energy storage system based on the allowable charge or discharge power comprises:
sending a first charge power of the battery pack determined based on the allowable charge or discharge power to the battery manager, so as to instruct the battery manager to control, based on the first charge power, the battery pack to undergo charging, wherein the first charge power is equal to a difference between the output power of the power generation module and the required system power;
controlling, upon receiving a first charge stop request sent by the battery manager, the power generation module to stop charging the battery pack;
sending a first discharge power of the battery pack determined based on the allowable charge or discharge power to the battery manager, so as to instruct the battery manager to control, based on the first discharge power, the battery pack to undergo discharging, wherein the first discharge power is equal to a difference between the required system power and the output power of the power generation module; and
controlling, upon receiving a first discharge stop request sent by the battery manager, the battery pack to stop discharging.

3. The SOH detection method according to claim 2, **characterized in that** the adjusting an output power of a power generation module in the energy storage system based on the allowable charge or discharge power further comprises:
controlling, after controlling the power generation module to stop charging the battery pack, the output power of the power generation module to be equal to the required system power so as to leave the battery pack to stand statically.

4. The SOH detection method according to claim 2, **characterized in that** the adjusting an output power of a power generation module in the energy storage system based on the allowable charge or discharge power further comprises:
controlling, after controlling the battery pack to stop discharging, the output power of the power generation module to be equal to the required system power so as to leave the battery pack to stand statically.

5. The SOH detection method according to claim 1, **characterized in that** the adjusting an output power of a power generation module in the energy storage system based on the allowable charge or discharge power comprises:
sending a second discharge power of the battery pack determined based on the allowable charge or discharge power to the battery manager, so as to instruct the battery manager to control, based on the second discharge power, the battery pack to undergo discharging, wherein the second discharge power is equal to a difference between the required system power and the output power of the power generation module;
controlling, upon receiving a second discharge stop request sent by the battery manager, the battery pack to stop discharging;
sending a second charge power of the battery pack determined based on the allowable charge or discharge power to the battery manager, so as to instruct the battery manager to control, based on the second charge power, the battery pack to undergo charging, wherein the second charge power is equal to a difference between the output power of the power generation module and the required system power; and
controlling, upon receiving a second charge stop request sent by the battery manager, the power generation module to stop charging the battery pack.

6. The SOH detection method according to claim 5, **characterized in that** the adjusting an output power of a power generation module in the energy storage system based on the allowable charge or discharge power further comprises:
controlling, after controlling the battery pack to stop discharging, the output power of the power generation module to be equal to the required system power so as to leave the battery pack to stand statically.

7. The SOH detection method according to claim 5, **characterized in that** the adjusting an output power of a power generation module in the energy storage system based on the allowable charge or discharge power further comprises:
controlling, after controlling the power generation module to stop charging the battery pack, the output power of the power generation module to be equal to the required system power so as to leave the battery pack to stand statically.

8. The SOH detection method according to any one of claims 1 to 7, **characterized in that** the sending an SOH detection instruction to a battery manager of a battery pack in the energy storage system comprises:
sending the SOH detection instruction to the battery manager of the battery pack in the energy storage system when it is determined that the output power of the power generation module is greater than the required system power for a duration greater than or equal to a preset SOH detection duration.

9. An SOH detection method, **characterized in that** the method is applied to a battery manager of a battery pack in an energy storage system, and the method comprises:
determining an allowable charge or discharge power of the battery pack in response to an SOH detection instruction sent by a main controller of the energy storage system;
sending the allowable charge or discharge power to the main controller, so that the main controller adjusts an output power of a power generation module in the energy storage system based on the allowable charge or discharge power, so as to cause the output power of the power generation module to charge or discharge the battery pack while satisfying a required system power; and
determining an available capacity of the battery pack upon completion of charging or discharging the battery pack, and calculating an SOH value of the battery pack based on the available capacity.

10. The SOH detection method according to claim 9, **characterized in that** the charging or discharging the battery pack comprise:
controlling, based on a first charge power sent by the main controller, the battery pack to undergo charging, wherein the first charge power is equal to a difference between the output power of the power generation module and the required system power;
sending, upon determining that the battery pack is fully charged, a first charge stop request to the main controller, so as to instruct the main controller to control the power generation module to stop charging the battery pack;
controlling, based on a first discharge power sent by the main controller, the battery pack to undergo discharging, wherein the first discharge power is equal to a difference between the required system power and the output power of the power generation module; and
sending a first discharge stop request to the main controller upon determining that the battery pack is fully discharged, so as to instruct the main controller to control the battery pack to stop discharging.

11. The SOH detection method according to claim 10, **characterized in that** the first charge stop request is further used for instructing the main controller to control, after controlling the power generation module to stop charging the battery pack, the output power of the power generation module to be equal to the required system power so as to leave the battery pack to stand statically.

12. The SOH detection method according to claim 10, **characterized in that** the first discharge stop request is further used for instructing the main controller to control, after controlling the battery pack to stop discharging, the output power of the power generation module to be equal to the required system power so as to leave the battery pack to stand statically.

13. The SOH detection method according to claim 9, **characterized in that** the charging or discharging the battery pack comprise:
controlling, based on a second discharge power sent by the main controller, the battery pack to undergo discharging, wherein the second discharge power is equal to a difference between the required system power and the output power of the power generation module;
sending a second discharge stop request to the main controller upon determining that the battery pack is fully discharged, so as to instruct the main controller to control the battery pack to stop discharging;
controlling, based on a second charge power sent by the main controller, the battery pack to undergo charging, wherein the second charge power is equal to a difference between the output power of the power generation module and the required system power; and
sending, upon determining that the battery pack is fully charged, a second charge stop request to the main controller, so as to instruct the main controller to control the power generation module to stop charging the battery pack.

14. The SOH detection method according to claim 13, **characterized in that** the second charge stop request is further used for instructing the main controller to control, after controlling the power generation module to stop charging the battery pack, the output power of the power generation module to be equal to the required system power so as to leave the battery pack to stand statically.

15. The SOH detection method according to claim 13, **characterized in that** the second discharge stop request is further used for instructing the main controller to control, after controlling the battery pack to stop discharging, the output power of the power generation module to be equal to the required system power so as to leave the battery pack to stand statically.

16. The SOH detection method according to any one of claims 9 to 15, **characterized in that** the SOH detection instruction is sent by the main controller when determining that the output power of the power generation module is greater than the required system power for a duration greater than or equal to a preset SOH detection duration.

17. A computer-readable storage medium, **characterized in that** the computer-readable storage medium stores a computer program, and, when executed by a computer device, the computer program causes the computer device to implement the SOH detection method according to any one of claims 1 to 8 or the SOH detection method according to any one of claims 9 to 16.

18. A main controller of an energy storage system, **characterized in that** the main controller comprises a memory and a processor, the memory stores a computer program, and, when executed by the processor, the computer program causes the main controller to implement the SOH detection method according to any one of claims 1 to 8.

19. A battery manager of a battery pack in an energy storage system, **characterized in that** the battery manager comprises a memory and a processor, the memory stores a computer program, and, when executed by the processor, the computer program causes the battery manager to implement the SOH detection method according to any one of claims 9 to 16.

20. An energy storage system, **characterized in that** the energy storage system comprises a power generation module, an energy conversion module, a battery pack, and a main controller; and the energy conversion module is configured to convert electrical energy generated by the power generation module, so as to charge the battery pack and/or supply power to an external device, or is configured to convert electrical energy provided by the battery pack, so as to supply power to an external device;
the main controller is configured to send an SOH detection instruction to a battery manager in the battery pack;
the battery manager is configured to determine an allowable charge or discharge power of the battery pack upon receiving the SOH detection instruction, and send the allowable charge or discharge power to the main controller;
the main controller is further configured to adjust an output power of the power generation module based on the allowable charge or discharge power, so that when converted by the energy conversion module, the output power of the power generation module satisfies a required system power for supplying power to an external device and a charge or discharge power for charging or discharging the battery pack; and
the battery manager is further configured to determine an available capacity of the battery pack upon completion of charging or discharging the battery pack, calculate an SOH value of the battery pack based on the available capacity, and send the SOH value of the battery pack to the main controller.
